# EUROPEAN PATENT SPECIFICATION

(11) **EP 0 426 271 B1**
(45) Date of publication and mention of the grant of the patent: **06.09.1995**
(21) Application number: 90304513.6
(22) Date of filing: 26.04.1990
(51) Int. Cl.: G11C 5/14

(54) **Portable semiconductor storage device**
Tragbare Halbleiterspeicheranordnung
Dispositif de mémoire à semi-conducteurs portable

(30) Priority: 02.11.1989 JP 284854/89
(43) Date of publication of application: 08.05.1991
(73) Proprietor: MITSUBISHI DENKI KABUSHIKI KAISHA, Tokyo (JP)
(72) Inventor: Kimura, Masatoshi, c/o Kitaitmai Seisakusho of, Itami City, Hyogo Prefecture (JP)
(74) Representative: Hackett, Sean James

(56) References cited:
- DE-A- 3 416 780
- DE-U- 8 535 374
- US-A- 4 868 074
- PATENT ABSTRACTS OF JAPAN vol. 011, no. 099 (E-493)27 March 1987 & JP-A-61 250 965
- PATENT ABSTRACTS OF JAPAN vol. 012, no. 460 (P-795)5 December 1988 & JP-A-63 183 428
- PATENT ABSTRACTS OF JAPAN vol. 013, no. 164 (E-745)19 April 1989 & JP-A-63 316 937
- PATENT ABSTRACTS OF JAPAN vol. 014, no. 050 (P-0998)30 January 1990 & JP- A-12 079 493

## Description

### BACKGROUND OF THE INVENTION

### Field of the Invention

The present invention relates to a portable semiconductor storage device and particularly it relates to a semiconductor storage device capable of replacing a cell provided in it to hold stored data safely and easily.

### Description of the Related Art

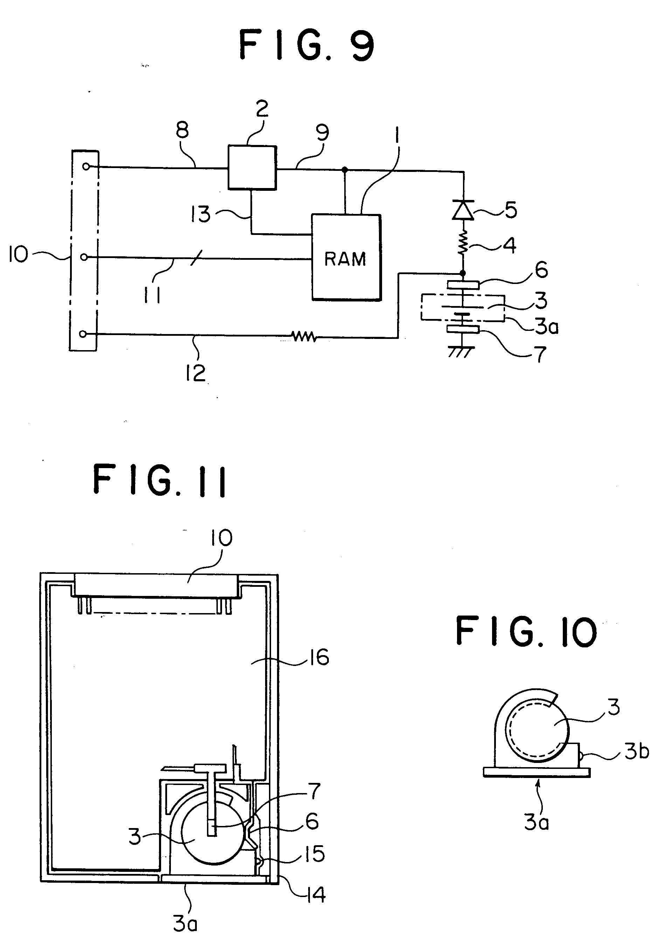

A conventional portable semiconductor storage device has such a configuration as that shown in Figure 9. The storage device has a static RAM 1, a cell 3 connected to the RAM 1 via an internal power-supply line 9 for supplying a power-supply voltage, a diode 5 for preventing reverse charging and a current limiting resistor 4. The cell 3 is held in a cell holder 3a which is removably provided in this storage device. The cell 3 is arranged to be electrically connected by stationary electrode terminals 6 and 7 when the cell holder 3a is inserted into the storage device. A power-supply input line 8 is connected to the internal power-supply line 9 via a power-supply control circuit 2. The power-supply input line 8 is connected to a connector 10. An interface bus 11 and a cell monitor output line 12 are connected to the connector 10 from the RAM 1 and the stationary electrode terminal 6 on the positive electrode of the cell 3 respectively. The section between the power-supply circuit 2 and the RAM 1 is connected by a control line 13.

A storage device thus configured is mounted on a terminal equipment (not shown) via the connector 10 when in use. If a power-supply voltage above a prescribed value is applied to the power-supply input line 8, the power-supply control circuit 2 causes this power-supply input line 8 and the internal power-supply line 9 to be conducted and sends out a high-level control signal to the RAM 1 via the control line 13. As a result, a power-supply voltage is supplied to the RAM 1 via the internal power-supply line 9. The RAM 1 is brought into an enable (operable) state by the high-level control signal. That is, the terminal equipment can make an access to the RAM 1, for example, reading from or writing into the RAM 1 via the interface bus 11.

When access to the RAM 1 is complete and a predetermined power-supply voltage is no longer applied to the power-supply input line 8, the power-supply control circuit 2 detects that the voltage value of the power-supply input line 8 has fallen below the prescribed value. The power-supply control circuit 2 shuts off the section between the power-supply input line 8 and the internal power-supply line 9, and sends out a low-level control signal to the RAM 1 via the control line 13. The RAM 1 is brought into a disable (non-operable) state by this signal, and an access to it by the interface bus 11 is prohibited. At this time, the power supply voltage from the power-supply input line 8 is not supplied to the RAM 1, but the voltage of the cell 3 is supplied to it via the resistor 4 and the diode 5. Therefore, if this storage device is removed from the terminal equipment, the stored data within the RAM 1 is not erased but held.

The cell 3 is gradually used up by supplying a voltage to the RAM 1. The voltage of the cell 3 is checked by the terminal equipment via the cell monitor output line 12 when the storage device is mounted on the terminal equipment. When the terminal voltage of the cell 3 falls below a predetermined voltage and the replacement of the cell 3 becomes necessary, the cell 3 can be removed from the storage device together with the cell holder 3a and replaced with a new one.

One example of the cell holder 3a is shown in Figure 10. A projection 3b is formed on a side of the cell holder 3a. As shown in Figure 11, when the cell holder 3a is inserted in the storage device, the projection 3b of the cell holder 3a is fitted into a recessed portion 15 formed on a frame 14 of the storage device, and the cell holder 3a is fixed. At this time, the stationary electrode terminals 6 and 7 contact the positive and negative electrodes of the held cell 3 respectively. In Figure 11, reference numeral 16 indicates a printed circuit board, on which is formed each of the circuit elements shown in Figure 9.

However, if the cell holder 3a is removed to replace the cell 3 under the condition that a predetermined voltage is not applied to the power-supply input line 8, supply of power to the RAM 1 is stopped, the stored data within the RAM 1 being erased. Accordingly, the replacement of the cell 3 has to be made under the condition that a storage device is mounted on the terminal equipment and a predetermined voltage is applied to the power-supply input line 8 via the connector 10. As a result, there exists the problem that the work for replacing cells is very inefficient and inconvenient.

Also, as electronic equipment become smaller and thinner, it is sometimes virtually impossible to replace a cell with a storage device mounted on a terminal equipment.

Patent Abstracts of Japan, volume 12, No. 460 (P-795) corresponding to Japanese patent specification JP-A-63183428 relating to a memory backup device comprising the features defined in the pre-characterising portion of claim 1.

German utility model DE-U-8535374 is directed to a battery holder having a complex construction which enables the connection of a replacement battery before removal of an old one.

### SUMMARY OF THE INVENTION

The present invention has been devised to solve the above-described problems. An object of the present invention is to provide a portable semiconductor storage device capable of replacing a built-in cell safely and easily without erasing stored data.

According to the present invention: there is provided a portable semiconductor storage device, comprising: a device main body; a storage circuit for storing data; a main cell for supplying a power-supply voltage to said storage circuit; an auxiliary cell for supplying a power-supply voltage to said storage circuit at the time of replacement of said main cell; and switch means for operating by mechanically linking with the mounting and removing operation of a main cell holder to electrically shut off said auxiliary cell from said storage circuit when said main cell holder is mounted in said device main body and electrically connect said auxiliary cell to said storage device when said main cell holder is removed from said device main body; characterised in that said main cell holder is removably provided in said device main body to hold said main cell; and a connector is provided for receiving power from externally of the device.

### BRIEF DESCRIPTION OF THE DRAWINGS

Figure 1 is a circuit diagram illustrating the portable semiconductor storage device according to one embodiment of the present invention;
Figure 2 is a timing chart of connection and disconnection for each of main and auxiliary cells;
Figures 3 and 4 are plan views respectively illustrating an essential portion of a second embodiment;
Figure 5 is a partial plan view illustrating a modification of the second embodiment;
Figures 6 and 7 are plan views respectively illustrating essential portions of a third embodiment;
Figure 8 is a plan view illustrating an essential portion of a fourth embodiment;
Figure 9 is a circuit diagram illustrating the portable semiconductor storage device of an example of the conventional art;
Figure 10 is a plan view illustrating the cell holder of an example of the conventional art; and
Figure 11 is a schematic plan view illustrating an example of the conventional art.

### DESCRIPTION OF THE PREFERRED EMBODIMENTS

The embodiments will be explained hereinbelow with reference to the drawings.

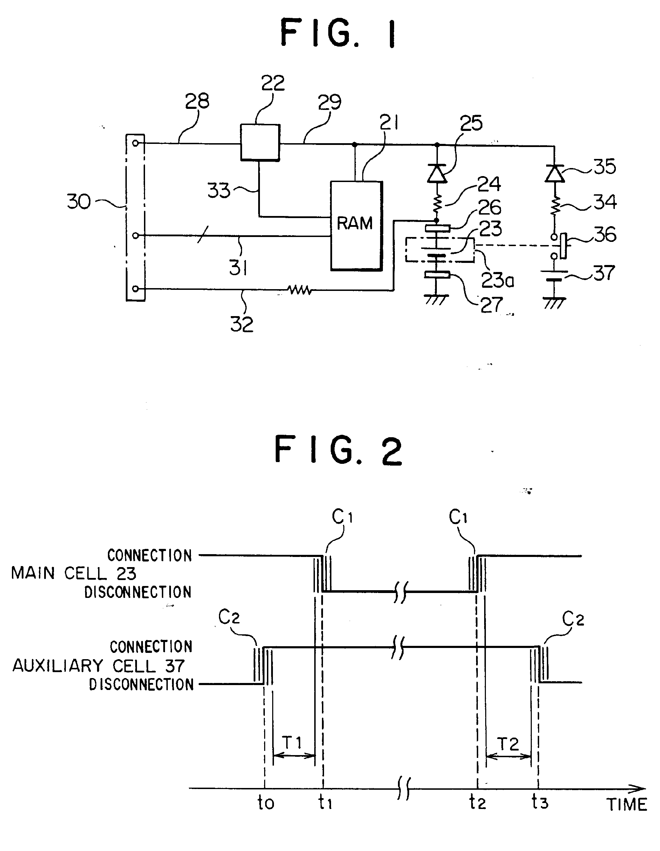

In Figure 1, the storage device has a static RAM 21. An internal power supply line 29 for supplying a power-supply voltage is connected to the RAM 21. A main cell 23 is connected to the internal power supply line 29 via a first reverse charging prevention diode 25 and a first current limiting resistor 24. The main cell 23 is held in a main cell holder 23a removably provided in this storage device. When the main cell holder 23a is inserted into the storage device, the main cell 23 is electrically connected to stationary electrode terminals 26 and 27. Furthermore, an auxiliary cell 37 is connected to the internal power supply line 29 via a second reverse charging prevention diode 35, a second current limiting resistor 34 and switch means 36.

The switch means 36 is operated by mechanically linking with the mounting and removing operation of the main cell holder 23a. It is opened when the main cell holder 23a is mounted in the device main body (not shown) to connect the main cell 23 between the stationary electrode terminals 26 and 27, while it is short-circuited when the main cell holder 23a is removed form the device main body.

A power-supply input line 28 is connected to the internal power supply line 29 via a power-supply control circuit 22, and the power-supply input line 28 is connected to a connector 30. An interface bus 31 and a cell monitor output line 32 are connected to the connector 30 from the RAM 21 and the stationary electrode terminal 26 on the positive polarity side of the main cell 23 respectively. The section between the power-supply control circuit 22 and the RAM 21 is connected by a control line 33.

The operation of this embodiment will now be explained. The storage device shown in Figure 1 is mounted on a terminal equipment (not shown) via the connector 30 when in use. When a predetermined power-supply voltage is applied to the power-supply input line 28 from the terminal equipment, the power-supply control circuit 22 detects this, conducts the power-supply input line 28 and the internal power-supply line 29, and sends out a high-level control signal to the RAM 21 via the control line 33. As a result, the RAM 21 is supplied with a power-supply voltage via the internal power-supply line 29, and is brought into an enable state by the high-level control signal. That is, the terminal equipment can make an access to the RAM 21, for example, reading from and writing into the RAM 21 via the interface bus 31.

When access to the RAM 21 is complete and a predetermined power-supply voltage is no longer applied to the power-supply input line 28, the power-supply control circuit 22 detects that the voltage value of the power-supply input line 28 has fallen below the prescribed value. The power-supply control circuit 22 shuts off the section between the power-supply input line 28 and the internal power-supply line 29, and sends out a low-level control signal to the RAM 21 via the control line 33. The RAM 21 is brought into a disable state by this signal, and any access to it is prohibited. At this time, the power-supply voltage from the power-supply input line 28 is not supplied to the RAM 21, but the voltage of the main cell 23 is supplied to it via the resistor 24 and the diode 25. Therefore, if this storage device is removed from the terminal equipment, the stored data within the RAM 21 is not erased, instead it is held.

The main cell 23 which holds stored data of the storage device thus removed from the terminal equipment is gradually used up by supplying voltage to the RAM 21. The voltage of the main cell 23 is checked by the terminal equipment via the cell monitor output line 32 when the storage device is mounted on the terminal equipment. When the terminal voltage of the cell 23 falls below a predetermined voltage and the replacement of the main cell 23 becomes necessary, the main cell 23 is removed from the device main body together with the main cell holder 23a and replaced with a new one.

At this time, the switch means 36 is operated by being linked with the removal operation of the main cell holder 23a. As a result, the auxiliary cell 37 and the second current limiting resistor 34 are connected with each other, and a voltage is supplied to the RAM 21 from the auxiliary cell 37 via switch means 36, the resistor 34 and the diode 35. Therefore, if the main cell 23 is removed from the storage device together with the main cell holder 23a under the condition that the storage device is not mounted on the terminal equipment, the stored data within the RAM 21 is held without being erased. When the used main cell 23a is replaced and the removed main cell holder 23a holding a new main cell 23 is mounted in the device main body again, the switch means 36 is opened by being linked with the insertion operation of the main cell holder 23a. Therefore, the auxiliary cell 37 is separated from the RAM 21, and instead the new main cell 23 supplies a voltage to the RAM 21 via the resistor 24 and the diode 25.

As described above, the main cell 23 can easily be replaced while the stored data is held under the condition that the storage device is not mounted on the terminal equipment but in a portable state.

To prevent the supplying of power to the RAM 21 from stopping for even a short period of time when the main cell holder 23a is removed from the device main body, a predetermined timing is required between the mounting and removing operation of the main cell holder 23a and the operation of the switch means 36 which operates by linking with the operation of the main cell holder 23a. That is, as shown in Figure 2, when the main cell holder 23a is removed, it is required that at time t₀ before time t₁ when the main cell 23 is separated from the stationary electrode terminals 26 and 27, the switch means 36 is short-cicuited, causing the auxiliary cell 37 to be connected to the RAM 21. On the other hand, when the main cell holder 23a is inserted, it is required that at time t₃ after time t₂ when the main cell 23 is connected to the stationary electrode terminals 26 and 27, the switch means 36 is opened and the auxiliary cell 37 is shut off from the RAM 21. Actually, the time period must be set by considering the chatterings C₁ and C₂ of each contact. As shown in Figure 2, even if the chatterings C₁ and C₂ are eliminated, the timing should preferably have time T1 and T2 if both the main cell 23 and the auxiliary cell 37 are to be reliably connected to the RAM 21.

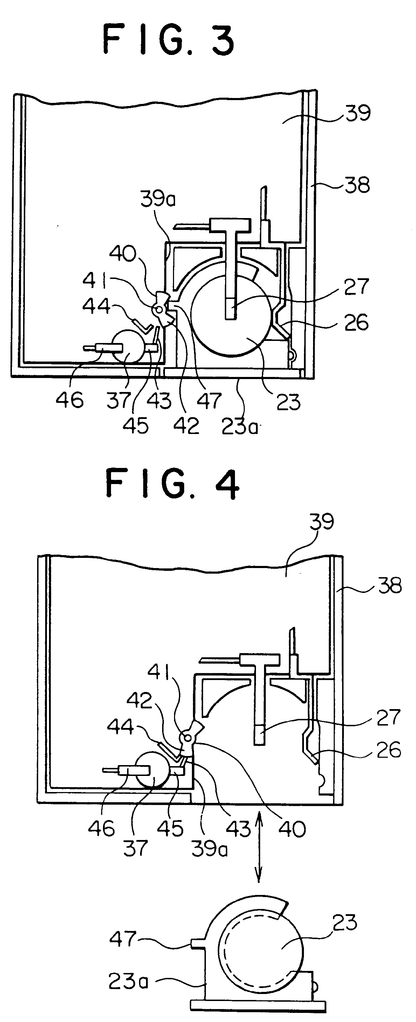

An essential part of a second embodiment is shown in Figure 3. A printed circuit board 39 is fixed within a frame 38 constituting a device main body. A notch 39a is formed on one corner of this printed circuit board 39, and the main cell holder 23a is inserted in the frame 38 in this portion. The stationary electrode terminals 26 and 27, each of which has one end fixed to the printed circuit board 39, are placed within the notch 39a of the printed circuit board 39, and contact the positive and negative polarities of the main cell 23 held in the main cell holder 23a respectively. A rotary slide switch 40 is formed on a portion of the printed circuit board 39 facing the notch 39a. This rotary slide switch 40 includes a movable contact 42 rotatably provided around a fulcrum 41 and a pair of fixed contacts 43 and 44 fixed on the printed circuit board 39. The auxiliary cell 37 is placed in the vicinity of the rotary slide switch 40. The auxiliary cell 37 is attached with tabs 45 and 46 which are connected to the positive and negative polarities of the auxiliary cell 37, and the tab 45 on the positive side is connected to the fixed contact 43 of the rotary slide switch 40 by soldering.

Although not shown, each of the circuit elements shown in Figure 1 is formed on the printed circuit board 39. The stationary electrode terminal 27 and the tab 46 on the negative side of the auxiliary cell 37 are connected to the ground line, and the other stationary electrode terminal 26 and the fixed contact 44 of the rotary slide switch 40 are connected to corresponding circuit elements respectively.

A projection 47 for actuating the rotary slide switch 40 is formed on the main cell holder 23a. For this reason, when the main cell holder 23a is inserted in the frame 38 as shown in Figure 3, the projection 47 of the main cell holder 23a contacts the movable contact 42 of the rotary slide switch 40 and causes the movable contact 42 to be fixed to a position away from the fixed contacts 43 and 44. That is, the rotary slide switch 40 is opened, and the auxiliary cell 37 is electrically shut off from the not-shown RAM.

However, when the main cell holder 23a is removed from the frame 38 to replace the main cell 23, the movable contact 42 of the rotary slide switch 40 is made to rotate clockwise by the projection 47 of the main cell holder 23a, and as shown in Figure 4, it is positioned on the fixed contacts 43 and 44, these contacts being electrically short-circuited. That is, the rotary slide switch 40 is turned on, and the auxiliary cell 37 is connected to the not-shown RAM.

When the main cell 23 is replaced and the main cell holder 23a holding a new main cell 23 is inserted in the frame 38 again, the positive and negative electrodes of the main cell 23 contact the fixed electrode terminals 26 and 27 to be electrically connected. This time, the projection 47 of the main cell holder 23a causes the movable contact 42 of the rotary slide switch 40 to rotate counterclockwise. As shown in Figure 3, therefore, the movable contact 42 is separated from the fixed contacts 43 and 44, and the section between these fixed contacts 43 and 44 is opened.

By making the contact stroke of the fixed electrode terminals 26 and 27 with the main cell 23 longer than that of the movable contact 42 required to short-circuit the section between the fixed contacts 43 and 44 of the rotary slide switch 40, the timing of connection and disconnection for each of the main cell 23 and the auxiliary cell 37 can be set as shown in Figure 2.

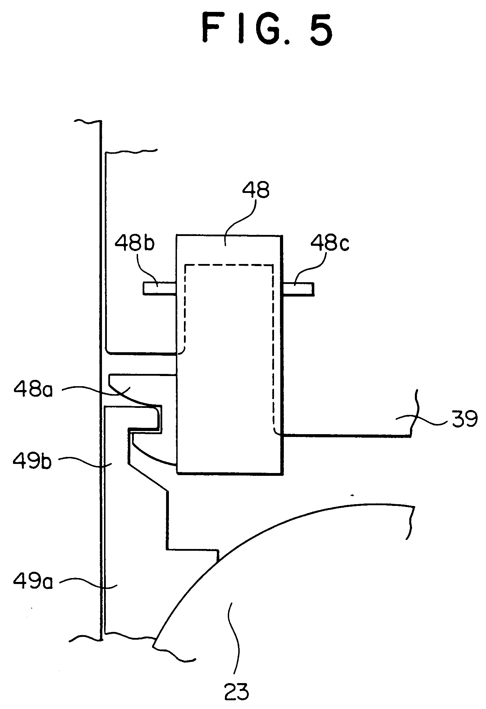

In the second embodiment described above, the movable contact 42 and the fixed contacts 43 and 44 are provided on the printed circuit board 39 to form the rotary slide switch 40. As shown in Figure 5, a rotary slide switch 48 formed of a combination of a movable contact 48a, and fixed contacts 48b and 48c is prepared as a single body in advance and this switch 48 may be mounted on the printed circuit board 39. Reference numeral 49b designates a projection formed on a main cell holder 49a holding the main cell 23.

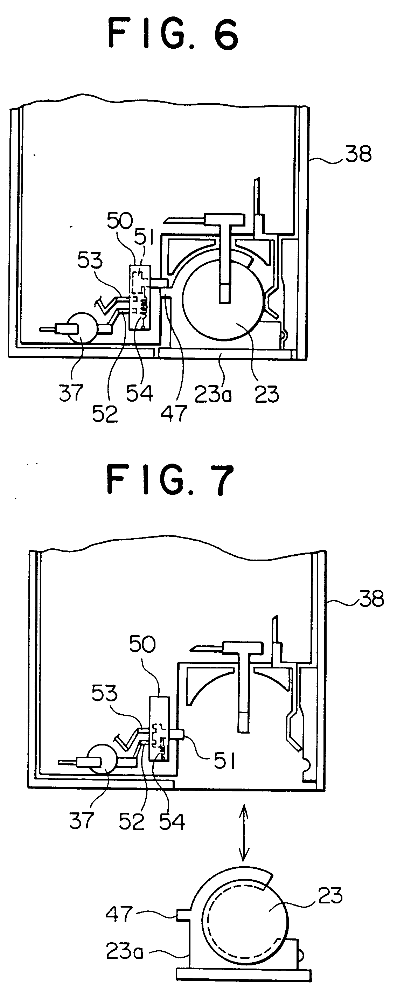

Figure 6 shows an essential part of a third embodiment. This third embodiment is one such that a push-off switch 50 is used as the switch means 36 instead of the rotary slide switch 40 in the second embodiment. The push-off switch 50 has a movable contact 51 which is provided linearly movably, and the fixed contacts 52 and 53 which are positionally fixed, and the movable contact 51 is energized toward the fixed contacts 52 and 53 by a spring 54.

As shown in Figure 6, when the main cell holder 23a is inserted, the projection 47 of the main cell holder 23a causes the movable contact 51 of the push-off switch 50 to move, and to be fixed to a position separated from the fixed contacts 52 and 53, thereby opening the push-off switch 50. That is, the auxiliary cell 37 is electrically shut off from a not-shown RAM.

On the other hand, as shown in Figure 7, when the main cell holder 23a is removed from the frame 38, the projection 47 of the main cell holder 23a becomes separated from the movable contact 51 of the main cell holder 23a, thereby causing the movable contact 51 to move onto the fixed contacts 52 and 53 due to the action of the spring 54. As a result, the push-off switch 50 becomes short-circuited. Accordingly, the auxiliary cell 37 is electrically connected to the not-shown RAM, and a power-supply voltage is supplied to the RAM from this auxiliary cell 37.

In this third embodiment, also, by making the contact stroke of the fixed electrode terminals 26 and 27 with the main cell 23 longer than that of the contact stroke of the movable contact 51 required to short-circuit the section between the fixed contacts 52 and 53 of the push-off switch 50, the timings of connection and disconnecion for each of the main cell 23 and the auxiliary cell 37 can be set as shown in Figure 2.

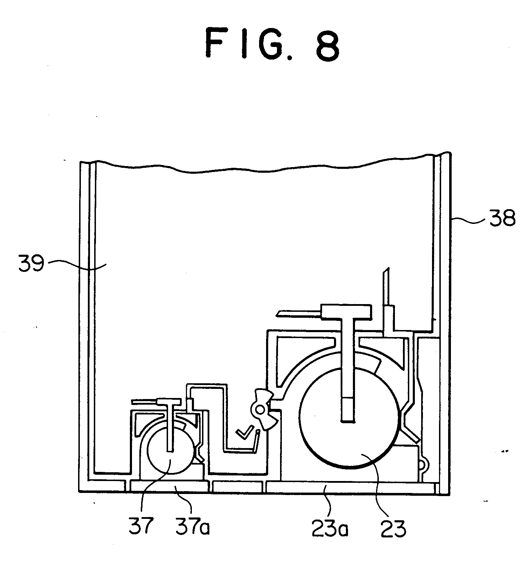

In the second and third embodiments, the auxiliary cell 37 with tabs was mounted on the printed circuit board 39. As shown in a fourth embodiment of Figure 8, an auxiliary cell holder 37a may be removably provided on the frame 38 so as to hold the auxiliary cell 37. Since it is not necessary for this auxiliary cell holder 37a to be linked with switch means, a holder similar to the conventional cell holder 3a shown in Figure 10 can be employed. By using the auxiliary cell holder 37a in this manner, the auxiliary cell 37 can be replaced easily, and furthermore convenience can be improved.

As the switch means 36, a switch having a multi-contact structure may be used. In this case, it is possible that the main cell 23 and the auxiliary cell 37 can be switched by using one contact and the information regarding the switching of these cells is output to the terminal via the connector 30 by using the other contacts. Therefore, for example, when the auxiliary cell 37 is in use, this can be displayed and an alarm sounded. Furthermore, the rotary slide switches 40, 48 and the push-off switch 50 are mounted on both sides of the printed circuit board 39, and these switches may simultaneously be operated by linking with the mounting and removing operation of the main cell holder 23a.

## Claims

1. A portable semiconductor storage device, comprising:
a device main body (38);
a storage circuit (21) for storing data;
a main cell (23) for supplying a power-supply voltage to said storage circuit;
an auxiliary cell (37) for supplying a power-supply voltage to said storage circuit at the time of replacement of said main cell; and
switch means (36) for operating by mechanically linking with the mounting and removing operation of a main cell holder (23a) to electrically shut off said auxiliary cell (37) from said storage circuit (21) when said main cell holder is mounted in said device main body and electrically connect said auxiliary cell to said storage device when said main cell holder is removed from said device main body; characterised in that
said main cell holder (23a) is removably provided in said device main body to hold said main cell; and
a connector (30) is provided for receiving power from externally of the device.

2. A storage device according to claim 1, wherein said switch means (36) electrically shuts off said auxiliary cell (37) from said storage circuit (21) after said main cell (23) is electrically connected to said storage circuit when said main cell holder is mounted, and electrically connects said auxiliary cell to said storage device before said main cell is electrically shut off from said storage circuit when said main cell holder is removed from said device main body (38).

3. A storage device according to claim 1, wherein said switch means is a rotary slide switch (40).

4. A storage device according to claim 1, wherein said switch means is a push-off switch (50).

5. A storage device according to claim 1, further comprising an auxiliary cell holder (37a) holding said auxiliary cell and removably provided on said device main body.

## Patentansprüche

1. Tragbare Halbleiter-Speichervorrichtung, die folgendes aufweist:
einen Vorrichtungs-Hauptkörper (38) ;
eine Speicherschaltung (21) zum Speichern von Daten;
eine Hauptzelle (23), um der Speicherschaltung eine Versorgungsspannung zuzuführen;
eine Hilfszelle (37), um der Speicherschaltung bei Austausch der Hauptzelle eine Versorgungsspannung zuzuführen; und
eine Schalteinrichtung (36), die durch mechanische Kopplung mit dem Einsetz- und Entnahmevorgang eines Hauptzellenhalters (23a) betätigt wird, um die Hilfszelle (37) von der Speicherschaltung (21) elektrisch abzuschalten, wenn der Hauptzellenhalter in dem Vorrichtungs-Hauptkörper angebracht wird, und die Hilfszelle mit der Speichervorrichtung elektrisch zu verbinden, wenn der Hauptzellenhalter aus dem Vorrichtungs-Hauptkörper entnommen wird, dadurch gekennzeichnet, daß der Hauptzellenhalter (23a) in dem Vorrichtungs-Hauptkörper herausnehmbar vorgesehen ist, zum die Hauptzelle zu halten; und
ein Verbinder (30) vorgesehen ist, um Leistung von außerhalb der Vorrichtung aufzunehmen.

2. Speichervorrichtung nach Anspruch 1, wobei die Schalteinrichtung (36) die Hilfszelle (37) von der Speicherschaltung (21) elektrisch abschaltet, nachdem die Hauptzelle (23) mit der Speicherschaltung elektrisch verbunden ist, wenn der Hauptzellenhalter angebracht ist, und die Hilfszelle elektrisch mit der Speichervorrichtung verbindet, bevor die Hauptzelle von der Speicherschaltung elektrisch abgeschaltet wird, wenn der Hauptzellenhalter von dem Vorrichtungs-Hauptkörper (38) abgenommen wird.

3. Speichervorrichtung nach Anspruch 1, wobei die Schalteinrichtung ein Drehschiebeschalter (40) ist.

4. Speichervorrichtung nach Anspruch 1, wobei die Schalteinrichtung ein Schubausschalter (50) ist.

5. Speichervorrichtung nach Anspruch 1, die ferner einen Hilfszellenhalter (37a) aufweist, der die Hilfszelle haltert und an dem Vorrichtungs-Hauptkörper abnehmbar vorgesehen ist.

## Revendications

1. Dispositif de mémoire à semi-conducteurs portable, comprenant :
un corps principal du dispositif (38) ;
un circuit de mémoire (21) pour mémoriser des données ;
une cellule principale (23) pour fournir une tension d'alimentation audit circuit de mémoire ;
une cellule auxiliaire (37) pour fournir une tension d'alimentation audit circuit de mémoire au moment du remplacement de ladite cellule principale ;
un moyen de commutation (36) pour activation par liaison mécanique avec l'opération de montage et de retrait d'un support de cellule principale (23a) pour couper électriquement ladite cellule auxiliaire (37) dudit circuit de mémoire (21) lorsque le support de cellule principale est monté dans ledit corps principal du dispositif et relier électriquement ladite cellule auxiliaire audit dispositif de mémoire lorsque ledit support de cellule principale est retiré dudit corps principal du dispositif ; caractérisé en ce que
le support de cellule principale (23a) est prévu amoviblement dans ledit corps principal du dispositif pour maintenir ladite cellule principale ; et
un connecteur (30) est prévu pour recevoir de l'énergie de l'extérieur du dispositif.

2. Dispositif de mémoire selon la revendication 1, dans lequel le moyen de commutation précité (36) coupe électriquement la cellule auxiliaire précitée (37) du circuit de mémoire précité (21) après que la cellule principale précitée (23) soit électriquement reliée audit circuit de mémoire lorsque le support de cellule principale précité est monté et relie électriquement la cellule auxiliaire précitée au dispositif de mémoire avant que la cellule principale soit électriquement coupée du circuit de mémoire lorsque le support de cellule principale est retiré du corps principal du dispositif précité (38).

3. Dispositif de mémoire selon la revendication 1, dans lequel le moyen de commutation précité est un commutateur glissant rotatif (40).

4. Dispositif de mémoire selon la revendication 1, dans lequel le moyen de commutation précité est un commutateur de mise en route (50).

5. Dispositif de mémoire selon la revendication 1, comprenant de plus un support de cellule auxiliaire (37a) maintenant la cellule auxiliaire précitée et prévu amoviblement sur le corps principal du dispositif précité.
